# EUROPÄISCHE PATENTSCHRIFT

(11) **EP 3 216 670 B1**
(45) Veröffentlichungstag und Bekanntmachung des Hinweises auf die Patenterteilung: **05.09.2018**
(21) Anmeldenummer: 17159298.3
(22) Anmeldetag: 06.03.2017
(51) Int. Cl.: B61D 27/00, H05K 7/20, B61C 3/00, B61C 17/00, F28F 27/02

(54) **VERFAHREN ZUM BETREIBEN EINES KÜHLSYSTEMS FÜR EIN FAHRZEUG SOWIE KÜHLSYSTEM**
METHOD OF OPERATING A REFRIGERATION SYSTEM FOR A VEHICLE AND COOLING SYSTEM
PROCEDE DE FONCTIONNEMENT D'UN SYSTEME DE REFROIDISSEMENT POUR UN VEHICULE ET SYSTEME DE REFROIDISSEMENT

(30) Priorität: 10.03.2016 DE 102016203985
(43) Veröffentlichungstag der Anmeldung: 13.09.2017
(73) Patentinhaber: Mahle International GmbH, 70376 Stuttgart (DE)
(72) Erfinder: Frank, Stefan, 70839 Gerlingen (DE)
(74) Vertreter: BRP Renaud & Partner mbB Rechtsanwälte Patentanwälte Steuerberater

(56) Entgegenhaltungen:
- WO-A1-2010/046261
- DE-A1-102007 005 391
- DE-A1-102008 011 225
- DE-A1-102010 015 331
- DE-A1-102014 004 009
- DE-A1-102014 012 799

## Beschreibung

Die vorliegende Erfindung betrifft ein Verfahren zum Betreiben eines Kühlsystems für ein Fahrzeug, insbesondere für ein Schienenfahrzeug, gemäß dem Oberbegriff des Anspruchs 1. Die Erfindung betrifft desweiteren ein solches Kühlsystem gemäß dem Oberbegriff des Anspruchs 4. Ein solches Verfahren und ein solches Kühlsystem gehen aus dem Dokument DE 10 2007 005 391 A1 als bekannt hervor. In einem Kühlsystem zirkuliert üblicherweise ein Kühlmittel, das zum Kühlen von Flüssigkeiten und Gegenständen zum Einsatz kommt. Ein solches Kühlsystem kann insbesondere in einem Fahrzeug verwendet werden, um Komponenten des Fahrzeugs als Wärmequellen zu kühlen. Vorstellbar ist es hierbei, das Kühlsystem mit mehreren Kühlkreisen zu versehen, in denen ein Kühlmittel zirkuliert und im jeweiligen Kreis eine solche Wärmequelle zwecks Kühlung anzuordnen. Dabei kann je nach Kühlbedarf der Wärmequelle eine entsprechende Anpassung des Kühlkreises vorgenommen werden. Die Zirkulation des Kühlmittels im jeweiligen Kühlkreis erfolgt hierbei mittels einer Fördereinrichtung, die das Kühlmittel im Kühlkreis fördert.
Bei betriebskritischen Wärmequellen, insbesondere Komponenten des Fahrzeugs, ist es dabei erforderlich, eine Kühlung mit sehr hohen Wahrscheinlichkeiten zu gewährleisten bzw. eine Reduzierung der Kühlung und/oder einen Ausfall der Kühlung möglichst auszuschließen. Hierzu werden Kühlkreisen, in denen solche betriebskritische Wärmequellen angeordnet sind, häufig zwei solche Fördereinrichtungen zugeordnet, um bei einem Ausfall einer der Fördereinrichtungen die andere Fördereinrichtung zum Fördern des Kühlmittels einzusetzen. Zumindest eine der Fördereinrichtungen ist also als eine NotfallFördereinrichtung des Kühlkreises vorgesehen.

Eine solche Ausgestaltung des Kühlkreises führt dabei zu einem erhöhten Montageaufwand und/oder einem erhöhten Bauraumbedarf und/oder einem erhöhten Gewicht und/oder einer reduzierten Effizienz des Kühlsystems.

Die vorliegende Erfindung beschäftigt sich daher mit dem Problem, für ein Verfahren zum Betreiben eines Kühlsystems der vorstehend genannten Art sowie für ein derartiges Kühlsystem verbesserte oder zumindest alternative Ausführungsformen anzugeben, die sich insbesondere durch eine erhöhte Effizienz und/oder einen reduzierten Bauraumbedarf und/oder ein verringertes Gewicht auszeichnen.

Dieses Problem wird erfindungsgemäß durch die Gegenstände der unabhängigen Ansprüche gelöst. Vorteilhafte Ausführungsformen sind Gegenstand der abhängigen Ansprüche.

Die vorliegende Erfindung beruht auf dem allgemeinen Gedanken, bei einem Kühlsystem mit zwei Kühlkreisen, in denen jeweils eine Fördereinrichtung zum Fördern eines durch den jeweiligen Kühlkreis zirkulierenden Kühlmittels vorgesehen ist, wenigstens eine der Fördereinrichtungen einer der Kühlkreise als eine Notfallfördereinrichtung des anderen Kühlkreises einzusetzen. Hierdurch ist es insbesondere möglich, auf eigens für den Kühlkreis vorgesehene Notfallfördereinrichtungen zu verzichten. Dies führt zu einer Reduzierung des Bauraumbedarfs und/oder des Gewichts und/oder des Montageaufwands des Kühlsystems. Zudem kommt es hierdurch zu einer erhöhten Effizienz des Kühlsystems, da die als Notfallfördereinrichtung eingesetzte Fördereinrichtung in einem eigenen Kühlkreis Kühlmittel fördert und dementsprechend nicht lediglich zum Einsatz kommt, wenn eine andere Fördereinrichtung eine reduzierte Förderleistung liefert oder ausfällt. Dem Erfindungsgedanken entsprechend kommt also ein Kühlsystem mit einem ersten Kühlkreis und einem zweiten Kühlkreis zum Einsatz, in denen das Kühlmittel zirkuliert, wobei im ersten Kühlkreis eine erste Fördereinrichtung und im zweiten Kühlkreis eine zweite Fördereinrichtung zum Fördern des Kühlmittels vorgesehen ist. Bevorzugt ist es hierbei, wenn im ersten Kühlkreis und im zweiten Kühlkreis das gleiche Kühlmittel zirkuliert. Im jeweiligen Kühlkreis ist ferner eine Wärmequelle zwecks Kühlung angeordnet. Das heißt, dass im ersten Kühlkreis eine erste Wärmequelle und im zweiten Kühlkreis eine zweite Wärmequelle angeordnet ist. Die Wärmequellen werden dabei durch Wärmeaustausch mit dem Kühlmittel gekühlt. Hierzu ist eine Kühlung des Kühlmittels erforderlich, die mit Hilfe zumindest eines Kühlers des Kühlsystems erfolgt. In einem Normalbetrieb bzw. einem Regelbetrieb werden beide Fördereinrichtungen betrieben, um jeweils das Kühlmittel im zugehörigen Kühlkreis zu fördern. Dabei sind im Normalbetrieb die Kühlkreise bevorzugt fluidisch getrennt. Tritt ein Notfallbetrieb, der nachfolgend als erster Notfallbetrieb bezeichnet wird, ein, in dem die zweite Fördereinrichtung eine zumindest reduzierte Förderleistung zur Verfügung stellt, insbesondere ausfällt, wird Kühlmittel stromab der zweiten Wärmequelle vom zweiten Kühlkreis abgezweigt, von der ersten Fördereinrichtung gefördert und stromauf der zweiten Wärmequelle dem zweiten Kühlkreis zurückgeführt. Das heißt, dass das Kühlmittel zum Kühlen der zweiten Wärmequelle bei einem Ausfall der zweiten Fördereinrichtung von der ersten Fördereinrichtung gefördert und bei einer reduzierten Förderleistung der zweiten Fördereinrichtung zusätzlich von der ersten Fördereinrichtung gefördert wird. Bevorzugt ist es hierbei, wenn das Kühlmittel durch zumindest einen solchen Kühler geführt wird, bevor es der zweiten Wärmequelle zugeführt wird, so dass das Kühlmittel gekühlt wird, bevor es zwecks Kühlung der zweiten Wärmequelle zur zweiten Wärmequelle zurückgeführt wird.

Vorstellbar ist es hierbei insbesondere, das Verfahren derart auszugestalten, dass eine Priorisierung des zweiten Kühlkreises bzw. der zweiten Wärmequelle erfolgt, derart, dass lediglich ein Notfallbetrieb gemäß dem ersten Notfallbetrieb vorgesehen ist, bei dem ausschließlich eine Förderung des durch den zweiten Kühlkreis zirkulierenden Kühlmittels mit Hilfe der ersten Fördereinrichtung vorgesehen ist, wenn die Förderleistung der zweiten Fördereinrichtung zumindest reduziert ist, insbesondere wenn die zweite Fördereinrichtung ausfällt. Somit können im zweiten Kühlkreis solche Wärmequellen angeordnet werden, welche hinsichtlich der Kühlung kritischer sind, insbesondere eine während des Betriebs des Kühlsystems durchgehende Kühlung benötigen.

Das Kühlsystem kann prinzipiell in einer beliebigen Anwendung zum Einsatz kommen. Das Kühlsystem kommt bspw. in einem Fahrzeug zum Einsatz, um Komponenten des Fahrzeugs zu kühlen. Diese Komponenten des Fahrzeugs sind also besagte Wärmequellen. Vorstellbar ist es insbesondere, das Kühlsystem in einem Schienenfahrzeug einzusetzen, um Komponenten des Schienenfahrzeugs zu kühlen. Das Fahrzeug, insbesondere das Schienenfahrzeug, kann hierbei elektrisch angetrieben sein, so dass das Kühlsystem insbesondere zum Kühlen von Antriebskomponenten zum Einsatz kommen kann. Vorstellbar ist es hierbei insbesondere, betriebskritische Komponenten, insbesondere Antriebskomponenten, als zweite Wärmequellen im zweiten Kühlkreis anzuordnen, die, wie vorstehend erläutert, priorisiert werden können.

Selbstverständlich ist es auch möglich, das Kühlsystem auch derart zu betreiben, dass beim Eintritt eines zweiten Notfallbetriebs, in dem die erste Fördereinrichtung eine zumindest reduzierte Förderleistung zur Verfügung stellt, insbesondere ausfällt, Kühlmittel stromab der ersten Wärmequelle vom ersten Kühlkreis abgezweigt, von der zweiten Fördereinrichtung gefördert und stromauf der ersten Wärmequelle dem ersten Kühlkreis zurückgeführt wird. Im zweiten Notfallbetrieb wird also, analog zum ersten Notfallbetrieb, das Kühlmittel im ersten Kühlkreis bei einem Ausfall der ersten Fördereinrichtung von der zweiten Fördereinrichtung gefördert und bei einer Reduzierung der Förderleistung der ersten Fördereinrichtung, zusätzlich zur ersten Fördereinrichtung von der zweiten Fördereinrichtung gefördert.

Bevorzugt ist es ferner, dass beim Eintritt eines Unterstützungsbetriebs, in dem die Temperatur des Kühlmittels in einem der Kühlkreise stromauf oder stromab der zugehörigen Wärmequelle oberhalb eines vorgegebenen Wertes steigt, die Fördereinrichtung des anderen Kühlkreises zusätzlich zur Förderung des Kühlmittels im Kühlkreis mit der überhöhten Temperatur des Kühlmittels eingesetzt wird. Der Unterstützungsbetrieb kann also insbesondere auch dann erfolgen, wenn keine reduzierte Leistung der anderen Fördereinrichtung vorliegt. Hierbei kommt vorzugsweise wenigstens ein Temperatursensor zum Einsatz, der die Temperatur des Kühlmittels stromauf der zugehörigen Wärmequelle, und bevorzugt stromab des zugehörigen zumindest einen Kühlers, bestimmt. Dabei können ein erster Unterstützungsbetrieb und ein zweiter Unterstützungsbetrieb vorliegen, wobei im ersten Unterstützungsbetrieb die erste Fördereinrichtung zusätzlich zum Fördern des Kühlmittels im zweiten Kühlkreis zum Einsatz kommt, wenn die Temperatur des Kühlmittels im zweiten Kühlkreis stromauf der zweiten Wärmequelle oberhalb eines vorgegebenen Werts steigt. Analog hierzu wird im zweiten Unterstützungsbetrieb die zweite Fördereinrichtung zusätzlich zur Förderung des Kühlmittels im ersten Kühlkreis eingesetzt, wenn die Temperatur des Kühlmittels im ersten Kühlkreis stromauf der ersten Wärmequelle, und bevorzugt stromab des zumindest einen zugehörigen Kühlers, oberhalb eines vorgegebenen Werts steigt. Dabei können die vorgegebenen Werte der Temperatur im ersten Unterstützungsbetrieb und im zweiten Unterstützungsbetrieb unterschiedlich sein. Die zusätzliche Förderung im Unterstützungsbetrieb erfolgt dabei durch ein Abzweigen und Zurückführen des Kühlmittels vom bzw. zurück zu dem unterstützten Kühlkreis.

Das erfindungsgemäße Betriebsverfahren kommt bevorzugt in einem solchen Kühlsystem zum Einsatz, das eine Abzweig-Leitung zum fluidischen Verbinden des ersten Kühlkreises mit dem zweiten Kühlkreis stromauf der ersten Fördereinrichtung und stromauf der zweiten Fördereinrichtung aufweist, wobei die Abzweig-Leitung ferner stromab der zweiten Wärmequelle angeordnet ist. Das heißt, dass die Abzweig-Leitung bevorzugt von einer stromauf der ersten Fördereinrichtung angeordneten ersten Abzweigstelle des ersten Kühlkreises bis zu einer stromauf der zweiten Fördereinrichtung und stromab der zweiten Wärmequelle angeordneten zweiten Abzweigstelle des zweiten Kühlkreises verläuft. Die Abzweig-Leitung dient hierbei dem Zweck der Abzweigung des Kühlmittels vom zweiten Kühlkreis zum ersten Kühlkreis. Das Kühlsystem weist ferner eine erste Rückführ-Leitung zum fluidischen Verbinden des ersten Kühlkreises mit dem zweiten Kühlkreis auf, die stromab der ersten Fördereinrichtung vom ersten Kühlkreis abzweigt und stromauf der zweiten Wärmequelle, bevorzugt auch stromab der zweiten Fördereinrichtung, in den zweiten Kühlkreis mündet. Die erste Rückführ-Leitung dient hierbei insbesondere dem Zweck, dass zuvor über die Abzweig-Leitung aus dem zweiten Kühlkreis abgezweigte Kühlmittel dem zweiten Kühlkreis zuzuführen, wobei das Kühlmittel zuvor mittels der ersten Fördereinrichtung gefördert wurde. In der ersten Rückführ-Leitung ist ferner ein Ventil zur Regelung der Strömung des Kühlmittels angeordnet, die es insbesondere erlaubt, den Volumenstrom und/oder die Strömungsrichtung des Kühlmittels durch die erste Rückführ-Leitung zu regeln. Das Kühlsystem ist dabei derart ausgestaltet, dass es erfindungsgemäß betrieben werden kann. Das heißt insbesondere, dass die Abzweig-Leitung und die erste Rückführ-Leitung für den ersten Notfallbetrieb und/oder für den Unterstützungsbetrieb, insbesondere für den ersten Unterstützungsbetrieb, zum Einsatz kommen. Bei einer solchen Ausgestaltung ist die zweite Wärmequelle bzw. der zweite Kühlkreis priorisiert, da lediglich die erste Fördereinrichtung zum Fördern des Kühlmittels im zweiten Kühlkreis zum Einsatz kommen kann und ein umgekehrter Betrieb gemäß dem zweiten Notfallbetrieb nicht möglich ist.

Prinzipiell kann die erste Rückführleitung auch zum Rückführen von zuvor aus dem ersten Kühlkreis abgezweigtem Kühlmittel zum ersten Kühlkreis, insbesondere also im zweiten Notfallbetrieb, eingesetzt werden.

Selbstverständlich ist es auch möglich, eine zweite Rückführ-Leitung zum fluidischen Verbinden des zweiten Kühlkreises mit dem ersten Kühlkreis vorzusehen, die stromab der zweiten Fördereinrichtung vom zweiten Kühlkreis abzweigt und stromauf der ersten Wärmequelle sowie bevorzugt stromab der ersten Fördereinrichtung in den ersten Kühlkreis mündet. Die zweite Rückführ-Leitung kommt also insbesondere für den zweiten Notfallbetrieb und/oder für den Unterstützungsbetrieb, insbesondere für den zweiten Unterstützungsbetrieb, zum Einsatz. Hierbei kann das Kühlmittel aus dem ersten Kühlkreis über besagte Abzweig-Leitung oder eine andere Abzweig-Leitung abgezweigt werden. Bevorzugt ist es hierbei, wenn die Abzweig-Leitung zusätzlich stromab der ersten Wärmequelle angeordnet ist. Das heißt, dass die erste Abzweigstelle stromab der ersten Fördereinrichtung und stromauf der ersten Wärmequelle angeordnet ist.

Bei bevorzugten Ausführungsformen ist im zweiten Kühlkreis stromab der zweiten Fördereinrichtung und stromauf der ersten Rückführ-Leitung ein Ventil angeordnet, das derart ausgestaltet ist, dass es die Strömung des Kühlmittels von der ersten Rückführ-Leitung zur zweiten Fördereinrichtung über das Ventil verhindert. Dieses Ventil verhindert also insbesondere eine Strömung des Kühlmittels in die "falsche" Richtung. Somit wird insbesondere im ersten Notfallbetrieb verhindert, dass das über die erste Rückführ-Leitung dem zweiten Kühlkreis zurückgeführte Kühlmittel die zweite Wärmequelle umgehend zur Abzweig-Leitung gelangt.

Ein entsprechendes Ventil kann analog im ersten Kühlkreis stromab der ersten Fördereinrichtung und stromauf der zweiten Rückführ-Leitung angeordnet sein, um eine entsprechend "falsche" Richtung der Strömung des Kühlmittels, insbesondere im zweiten Notfallbetrieb, zu verhindern.

Bevorzugt sind Ausführungsformen, bei denen zumindest ein solches Ventil als ein Rückschlagventil ausgebildet ist. Der Einsatz eines solchen Rückschlagventils hat insbesondere den Vorteil, dass die derartige Ausgestaltung des Kühlkreises zum Ausführen des erfindungsgemäßen Verfahrens zumindest teilweise mittels der Rückschlagventile erfolgen kann, da diese eine Strömung des Kühlmittels nur in einer Richtung zulassen. Das heißt, dass ein in der ersten Rückführ-Leitung angeordnetes solches Rückschlagventil verhindert, das Kühlmittel über die erste Rückführ-Leitung vom zweiten Kühlkreis zum ersten Kühlkreis strömt. Analog hierzu kann ein solches in der zweiten Rückführ-Leitung angeordnetes Rückschlagventil eine Strömung des Kühlmittels vom ersten Kühlkreis zum zweiten Kühlkreis verhindern.

Ein solches Rückschlagventil hat ferner den Vorteil, dass es mit einem vorgegebenen Gegendruck betrieben werden kann, derart, dass das Rückschlagventil beim Überschreiten des Gegendrucks, insbesondere stetig, öffnet. Der Gegendruck des Rückschlagventils kann dabei derart gewählt werden, dass das Rückschlagventil bei einem vorgegebenen Druckunterschied zwischen dem ersten Kühlkreis und dem zweiten Kühlkreis öffnet, um eine entsprechende Strömung durch die zugehörige Leitung zu gewährleisten. Somit kann zumindest ein solcher Notfallbetrieb selbstregulierend erfolgen. Tritt in einem der Kühlkreise also aufgrund einer solchen Reduzierung der Förderleistung der zugehörigen Fördereinrichtung ein Druckverlust auf, öffnet das Rückschlagventil in der Abzweig-Leitung und/oder das Rückschlagventil in der zugehörigen Rückführ-Leitung selbstregelnd zum Realisieren eines solchen Notfallbetriebs.

Zudem kann bei einem Einsatz eines solchen Rückschlagventils in der Abzweig-Leitung bspw. verhindert werden, dass Kühlmittel über die Abzweig-Leitung vom ersten Kühlkreis zum zweiten Kühlkreis strömt. Hierdurch wird also insbesondere der zweite Notfallbetrieb verhindert und dementsprechend der zweite Kühlkreis bzw. die zweite Wärmequelle priorisiert.

Gemäß vorteilhafter Ausführungsformen ist in der Abzweig-Leitung ein Ventil zur Regelung der Strömung des Kühlmittels durch die Abzweig-Leitung angeordnet. Mittels des Ventils ist es also insbesondere möglich, während des Normalbetriebs eine fluidische Verbindung zwischen den Kühlkreisen zu verhindern, sowie während des jeweiligen Notfallbetriebs und/oder des Unterstützungsbetriebs den Volumenstrom des Kühlmittels durch die Abzweig-Leitung zu regeln.

Eine derartige Ausgestaltung des Kühlmittels zum Betreiben des erfindungsgemäßen Verfahrens kann alternativ oder zusätzlich auch durch eine Steuereinrichtung realisiert sein, die derart ausgestaltet ist, dass sie das Kühlsystem gemäß dem Verfahren betreibt. Hierzu kann die Steuereinrichtung mit dem jeweiligen Ventil kommunizierend verbunden sein, um die Ventile entsprechend anzusteuern. Bevorzugt ist die Steuereinrichtung zudem kommunizierend mit zumindest einer der Fördereinrichtungen verbunden, um den Betriebszustand der Fördereinrichtung zu überwachen und/oder zumindest eine der Fördereinrichtungen anzusteuern. Hierdurch ist es insbesondere möglich zu erkennen, ob die Förderleistung der Fördereinrichtung reduziert ist, um den entsprechenden Notfallbetrieb durchzuführen.

Zum Betreiben des Kühlsystems im Unterstützungsbetrieb ist die Steuereinrichtung ferner kommunizierend mit wenigstens einem solchen Temperatursensor verbunden, um beim Überschreiten der Temperatur des Kühlmittels oberhalb des zugehörigen vorgegebenen Werts den entsprechenden Unterstützungsbetrieb durchzuführen.

Als vorteilhaft erweisen sich Ausführungsformen, bei denen das Kühlsystem zumindest einen Druckausgleichsbehälter zum Ausgleich des Drucks im Kühlmittel aufweist, der fluidisch mit der Abzweig-Leitung verbunden sein kann. Der Druckausgleichsbehälter dient also dem Zweck, einen möglicherweise vorliegenden Druckunterschied zwischen dem ersten Kühlkreis und dem zweiten Kühlkreis auszugleichen, wobei dieser Ausgleich über die Abzweig-Leitung erfolgt.

Vorteilhaft ist es, wenn zwei solche Druckausgleichsbehälter, nämlich ein erster Druckausgleichsbehälter, der dem ersten Kühlkreis zugeordnet ist und ein zweiter Druckausgleichsbehälter, der dem zweiten Kühlkreis zugeordnet ist, vorgesehen sind. Damit kommt zum Druckausgleich im jeweiligen Kühlkreis in einem solchen Notfallbetrieb und/oder in Unterstützungsbetrieb, ein zugehöriger Druckausgleichsbehälter zum Einsatz. Dies erlaubt es insbesondere, einen der Kühlkreise auch betreiben zu können, wenn in dem anderen Kühlkreis ein Kühlmittelverlust eintritt. Insbesondere ist es hierdurch möglich, einen der Kühlkreise, insbesondere den zweiten Kühlkreis, insofern zu priorisieren, dass der zweite Kühlkreis auch dann geregelt weiter betreiben werden kann, wenn im ersten Kühlkreis ein Kühlmittelverlust eintritt.

Die jeweilige Leitung, das heißt die Abzweig-Leitung sowie die jeweilige Rückführ-Leitung kann bezüglich des zumindest einen Kühlers beliebig angeordnet sein. Hierbei ist es bevorzugt, wenn die Abzweig-Leitung und die jeweilige Rückführ-Leitung derart angeordnet sind, dass das Kühlmittel durch zumindest einen solchen Kühler geführt und gekühlt wird, bevor es nach dem Zurückführen der zugehörigen Wärmequelle zugeführt wird.

Vorstellbar ist es insbesondere, die Abzweig-Leitung stromauf des zumindest einen Kühlers anzuordnen. In der Folge wird das Kühlmittel im jeweiligen Notfallbetrieb bzw. im Unterstützungsbetrieb vom jeweiligen Kühlkreis abgezweigt, bevor es durch den Kühler geführt wird.

Denkbar ist es zudem, in zumindest einer der Leitungen alternativ oder zusätzlich zum Ventil eine Drosseleinrichtung zum Regeln der Strömung durch die Leitung anzuordnen. Insbesondere ist es vorstellbar, in zumindest einer der Leitungen zusätzlich zu wenigstens einem solchen Rückschlagventil eine solche Drosseleinrichtung vorzusehen. Somit kann die Strömung auch geregelt, insbesondere unterbrochen werden, wenn das zugehörige Rückschlagventil eine entsprechende Strömung zuließe. Bevorzugt ist es hierbei, wenn die jeweilige Drosseleinrichtung mit der Steuereinrichtung kommunizierend verbunden ist, so dass die Steuereinrichtung die Drosseleinrichtung ansteuern kann.

Das Kühlsystem kann prinzipiell für den jeweiligen Kühlkreis einen separaten Kühler aufweisen. Vorstellbar ist es auch, beiden Kühlkreisen einen gemeinsamen solchen Kühler zuzuordnen. Hierdurch kann insbesondere die Anzahl der Komponenten des Kühlkreises reduziert werden. Dabei ist es insbesondere vorstellbar, den jeweiligen Kühlkreis separat durch den gemeinsamen Kühler zu führen.

Der gemeinsame Kühler kann zwecks Kühlung des Kühlmittels von einem Kühlfluid durchströmbar sein, das in einer Kühlfluid-Strömungsrichtung durch den Kühler strömt. Das Kühlfluid kann hierbei insbesondere Luft, bspw. Fahrtwind des zugehörigen Fahrzeugs, sein.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Zeichnungen dargestellt und werden in der nachfolgenden Beschreibung näher erläutert, wobei sich gleiche Bezugszeichen auf gleiche oder ähnliche oder funktional gleiche Komponenten beziehen.

Es zeigen, jeweils schematisch sowie stark vereinfacht und schaltplanartig,
- Fig. 1: ein Kühlsystem in einem ersten Betriebszustand,
- Fig. 2: das Kühlsystem in einem zweiten Betriebszustand,
- Fig. 3: das Kühlsystem in einem weiteren Betriebszustand,
- Fig. 4: das Kühlsystem im zweiten Betriebszustand bei einem anderen Ausführungsbeispiel des Kühlsystems,
- Fig. 5: das Kühlsystem im ersten Betriebszustand, bei einem weiteren Ausführungsbeispiel des Kühlsystems,
- Fig. 6: das Kühlsystem aus Fig. 5 bei einem dritten Betriebszustand,
- Fig. 7: das Kühlsystem aus Fig. 5 bei einem weiteren Betriebszustand.

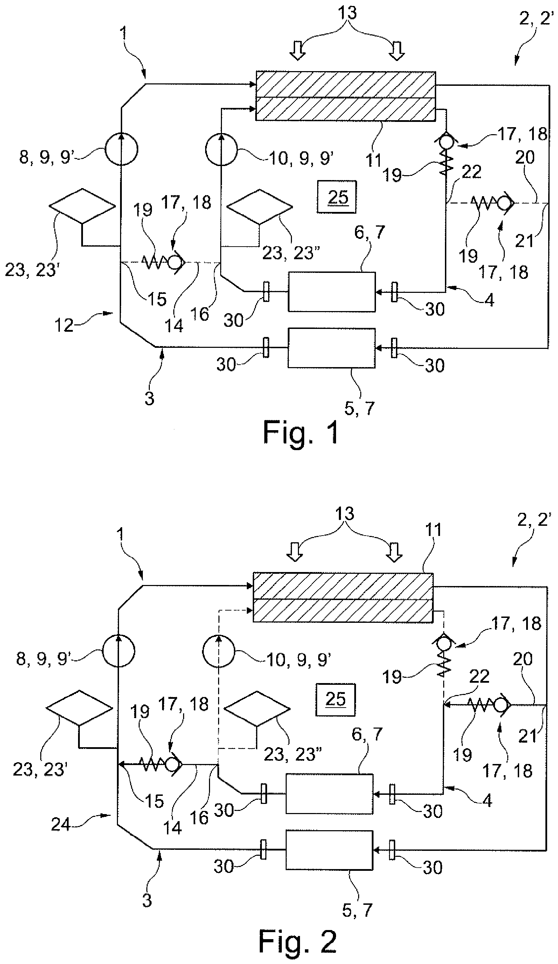

In Fig. 1 ist ein Kühlsystem 1 dargestellt, das Bestandteil eines Fahrzeugs 2, insbesondere eines Schienenfahrzeugs 2', bspw. eines elektrisch angetriebenen Schienenfahrzeugs 2' sein kann. Das Kühlsystem 1 weist einen ersten Kühlkreis 3 sowie einen zweiten Kühlkreis 4 auf, in denen ein Kühlmittel zirkuliert. Mit Hilfe des Kühlmittels wird im jeweiligen Kühlkreis 3, 4 eine Wärmequelle 5, 6 gekühlt, die im zugehörigen Kühlkreis 3, 4 angeordnet ist und vom Kühlmittel durchströmt oder umströmt wird. Dabei ist im ersten Kühlkreis 3 eine erste solche Wärmequelle 5 angeordnet, die bspw. eine Antriebskomponente 7 des Fahrzeugs 2 sein kann. Im zweiten Kühlkreis 4 ist eine zweite solche Wärmequelle 6 angeordnet, die ebenfalls eine Antriebskomponente 7 des Fahrzeugs 2 sein kann. Die im zweiten Kühlkreis 4 angeordnete Antriebskomponente 7 ist hinsichtlich der Kühlung kritischer als die im ersten Kühlkreis 3 angeordnete Antriebskomponente 7. Das heißt, dass die im zweiten Kühlkreis 4 angeordnete Antriebskomponente 7 zum Antreiben des Fahrzeugs 2 eine permanente Kühlung benötigt und/oder zum Antreiben des Fahrzeugs 2 wichtiger ist als die im ersten Kühlkreis 3 angeordnete Antriebskomponente 7.

Zum Fördern des Kühlmittels ist im ersten Kühlkreis 3 eine erste Fördereinrichtung 8, bspw. eine Pumpe 9, insbesondere eine Umwälzpumpe 9', angeordnet. Zudem ist zum Fördern des Kühlmittels im zweiten Kühlkreis 4 eine zweite Fördereinrichtung 10 angeordnet, die bspw. als Pumpe 9, insbesondere als Umwälzpumpe 9', ausgebildet ist. Die Kühlkreise 3, 4 weisen einen gemeinsamen Kühler 11 zum Kühlen des Kühlmittels auf, der im jeweiligen Kühlkreis 3, 4 stromab der Fördereinrichtung 8, 10 und stromauf der Wärmequelle 5, 6 angeordnet ist. Der Kühler 11 wird zur Kühlung des Kühlmittels von einem Kühlfluid durchströmt, das den Kühler 11 in einer Kühlfluid-Strömungsrichtung 13 durchströmt. Dabei sind der erste Kühlkreis 3 und der zweite Kühlkreis 4 getrennt durch den Kühler 11 geführt, wobei der erste Kühlkreis 3 bezüglich der Kühlfluid-Strömungsrichtung 13 stromauf des zweiten Kühlkreises 4 durch den Kühler 11 geführt ist. In Fig.1 ist ein Normalbetrieb 12 des Kühlsystems 1 dargestellt, in dem der erste Kühlkreis 3 und der zweite Kühlkreis 4 fluidisch getrennt sind und die erste Fördereinrichtung 8 das Kühlmittel im ersten Kühlkreis 3 fördert, während die zweite Fördereinrichtung 10 das Kühlmittel im zweiten Kühlkreis 4 fördert. Hierdurch ergibt sich im jeweiligen Kühlkreis 3, 4 eine Strömung des Kühlmittels, wobei sich nachfolgende Bezugnahmen auf die Kühlkreise 3, 4 im Sinne von stromauf und stromab auf die Strömung im jeweiligen Kühlkreis 3, 4 im Normalbetrieb 12 beziehen.

Das Kühlsystem 1 weist eine Abzweig-Leitung 14 auf, die den ersten Kühlkreis 3 und den zweiten Kühlkreis 4 fluidisch miteinander verbindet. Hierbei verläuft die Abzweig-Leitung 14 von einer stromab der ersten Wärmequelle 5 und stromauf der ersten Fördereinrichtung 8 angeordneten ersten Abzweigstelle 15 im ersten Kühlkreis 3 bis zu einer stromab der zweiten Wärmequelle 6 und stromauf der zweiten Fördereinrichtung 10 im zweiten Kühlkreis 4 angeordneten zweiten Abzweigstelle 16. In der Abzweig-Leitung 14 ist ein Ventil 17 angeordnet, das im gezeigten Beispiel als ein Rückschlagventil 18 ausgebildet ist. Das Rückschlagventil 18 erlaubt hierbei lediglich eine Strömung von Kühlmitteln vom zweiten Kühlkreis 4 zum ersten Kühlkreis 3. Das Rückschlagventil 18 ist mit einem Gegendruck belastet, der durch eine Feder 19 symbolisiert ist. Das heißt, dass zum Öffnen des Ventils 17 zwecks Strömung des Kühlmittels vom zweiten Kühlkreis 4 zum ersten Kühlkreis 3 der Gegendruck zu überwinden ist. Eine erste Rückführ-Leitung 20 verbindet den ersten Kühlkreis 3 fluidisch mit dem zweiten Kühlkreis 4 und verläuft von einer ersten Rückführstelle 21 der ersten Rückführ-Leitung 20 im ersten Kühlkreis 3 bis zu einer zweiten Rückführstelle 22 der ersten Rückführ-Leitung 20 im zweiten Kühlkreis 4. Hierbei ist die erste Rückführstelle 21 der ersten Rückführ-Leitung 20 stromab der ersten Fördereinrichtung 8 sowie stromauf der ersten Wärmequelle 5 und stromab des Kühlers 11 angeordnet. Die zweite Rückführstelle 22 der ersten Rückführ-Leitung 20 ist stromauf der zweiten Wärmequelle 6 sowie stromab der zweiten Fördereinrichtung 10 sowie stromab des Kühlers 11 angeordnet. In der ersten Rückführ-Leitung 20 ist ein Ventil 17 angeordnet, das wie das in der Abzweig-Leitung 14 angeordnete Ventil 17 als ein Rückschlagventil 18 ausgebildet und mit einem Gegendruck beaufschlagt ist und lediglich eine Strömung des Kühlmittels vom ersten Kühlkreis 3 zum zweiten Kühlkreis 4 zulässt. Stromauf der zweiten Rückführstelle 22 der ersten Rückführ-Leitung 20 und stromab der zweiten Fördereinrichtung 10 sowie stromab des Kühlers 11 ist im zweiten Kühlkreis 4 ein Ventil 17 angeordnet, das ebenfalls als ein Rückschlagventil 18 ausgebildet, mit einem Gegendruck beaufschlagt ist und lediglich eine Strömung des Kühlmittels von der Fördereinrichtung 10 zur zweiten Wärmequelle 6 erlaubt.

Im in Fig. 1 gezeigten Normalbetrieb 12 sind, wie vorstehend erwähnt, die Kühlkreise 3 und 4 voneinander getrennt. Dementsprechend strömt kein Kühlmittel durch die Abzweig-Leitung 14 oder durch die erste Rückführ-Leitung 20. In der Darstellung sind dabei Abschnitte, welche vom Kühlmittel nicht durchströmt sind, gestrichelt dargestellt. Das heißt, dass beim in Fig. 1 gezeigten Normalbetrieb 12 die Abzweig-Leitung 14 und die erste Rückführ-Leitung 20 gestrichelt dargestellt sind.

Im gezeigten Beispiel ist dem jeweiligen Kühlkreis 3, 4 ferner ein Druckausgleichsbehälter 23 zugeordnet. Das heißt, dass dem ersten Kühlkreis 3 ein erster solcher Druckausgleichsbehälter 23' zugeordnet ist, während dem zweiten Kühlkreis 4 ein zweiter solcher Druckausgleichbehälter 23" zugeordnet ist, wobei der jeweilige Druckausgleichsbehälter 23 dem Druckausgleich des Kühlmittels im zugehörigen Kühlkreis 3, 4 dient.

In Fig. 2 ist ein Notfallbetrieb 24 des Kühlsystems 1 gezeigt. Im Notfallbetrieb 24 liefert die zweite Fördereinrichtung 10 des zweiten Kühlkreises 4 eine reduzierte Leistung oder fällt aus, wobei in Fig. 2 ein Zustand dargestellt ist, bei dem die zweite Fördereinrichtung 10 ausgefallen ist. Im Notfallbetrieb 24 wird dabei Kühlmittel stromab der zweiten Wärmequelle 6 vom zweiten Kühlkreis 4 abgezweigt, dem ersten Kühlkreis 24 stromauf der Fördereinrichtung 8 zugeführt, mittels der ersten Fördereinrichtung 8 gefördert und dem zweiten Kühlkreis 4 wieder stromauf der zweiten Wärmequelle 6 zugeführt. Das heißt, dass die erste Fördereinrichtung 8 bei Ausfall der zweiten Fördereinrichtung 10 oder bei einer reduzierten Leistung der zweiten Fördereinrichtung 10 als Notfallfördereinrichtung des zweiten Kühlkreises 4 zum Einsatz kommt. Hierdurch wird die im zweiten Kühlkreis 4 angeordnete zweite Wärmequelle 6 auch dann gekühlt, wenn die zweite Fördereinrichtung 10 ausfällt oder eine reduzierte Leistung liefert. Dabei wird das Kühlmittel vom zweiten Kühlkreis 4 über die Abzweig-Leitung 14 dem ersten Kühlkreis 3 zugeführt und über die erste Rückführ-Leitung dem zweiten Kühlkreis 4 zurückgeführt. Im Notfallbetrieb 24 erfolgt die Kühlung des Kühlmittels über den Kühler 11 im gezeigten Beispiel also ausschließlich im ersten Kühlkreis 3. Das Rückschlagventil 18 in der Abzweig-Leitung 14 sorgt dafür, dass das Kühlmittel in der Abzweig-Leitung 14 vom zweiten Kühlkreis 4 zum ersten Kühlkreis 3 strömt, während das Rückschlagventil 18 in der ersten Rückführ-Leitung 20 dafür sorgt, dass das Kühlmittel über die erste Rückführ-Leitung 20 vom ersten Kühlkreis 3 zum zweiten Kühlkreis 4 strömt. Das im zweiten Kühlkreis 4 angeordnete Rückschlagventil 18 sorgt ferner dafür, dass das über die erste Rückführ-Leitung 20 zum zweiten Kühlkreis 4 strömende Kühlmittel nicht über die erste Fördereinrichtung 10 zur Abzweig-Leitung 14, sondern ausschließlich über die zweite Wärmequelle 6 zur Abzweig-Leitung 14 gelangt. Dieses Rückschlagventil 18 sorgt also dafür, dass das Kühlmittel im Notfallbetrieb 24 in die richtige Richtung bzw. nicht in die "falsche" Richtung strömt.

Die mit Gegendruck beaufschlagten Rückschlagventile 18 in der Abzweig-Leitung 14 und in der ersten Rückführ-Leitung 20 sorgen dabei dafür, dass die Ventile selbstregelnd öffnen, wenn sich die Druckverhältnisse zwischen dem ersten Kühlkreis 3 und dem zweiten Kühlkreis 4 aufgrund des durch die zumindest reduzierte Leistung der zweiten Fördereinrichtung 10 im zweiten Kühlkreis 4 fallenden Drucks im zweiten Kühlkreis 4 ändern. Das heißt insbesondere, dass der Notfallbetrieb 24 sich selbst regulierend einstellen kann. Alternativ oder zusätzlich ist es vorstellbar, das Kühlsystem 1 oder das Fahrzeug 2 mit einer Steuereinrichtung 25 zu versehen, die kommunizierend mit den entsprechenden Ventile 17 verbunden ist, um diese anzusteuern. Die Steuereinrichtung 25 ist zudem kommunizierend mit zumindest der zweiten Fördereinrichtung 10, bevorzugt mit beiden Fördereinrichtung 8, 10, verbunden, um insbesondere die jeweilige Fördereinrichtung 8, 10 anzusteuern und/oder die Förderleistung der jeweiligen Fördereinrichtung 8, 10 abzufragen. Zudem kann stromauf und/oder stromab der jeweiligen Wärmequelle 5, 6 ein Temperatursensor 30 zum Ermitteln der Temperatur des Kühlmittels stromauf bzw. stromab der zugehörigen Wärmequelle 5, 6 vorgesehen sein, die ebenfalls kommunizierend mit der Steuereinrichtung 25 verbunden ist.

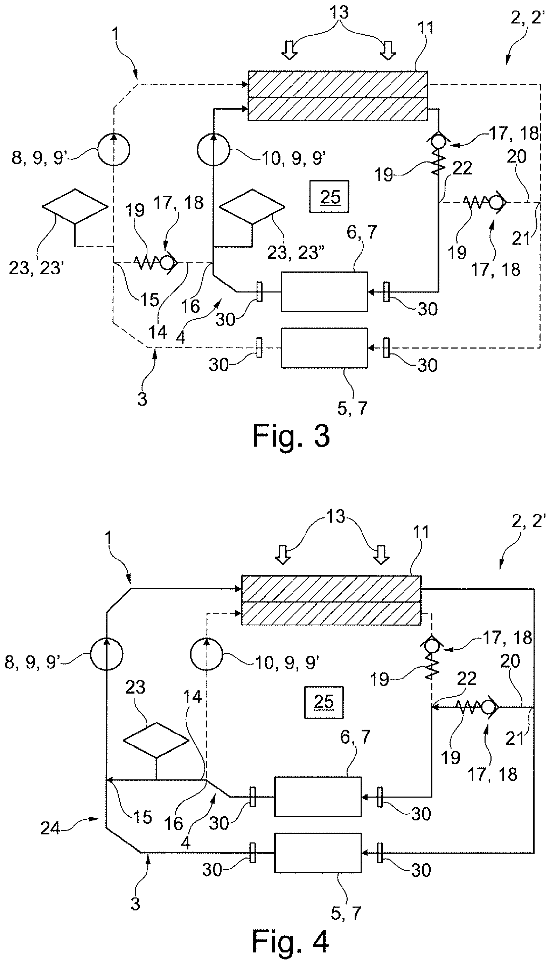

Beim in den Fig. 1 und 2 gezeigten Kühlsystem 1 wird dabei der zweite Kühlkreis 4 bzw. die zweite Wärmequelle 6 priorisiert. Das heißt, dass der Notfallbetrieb 24 lediglich zugunsten der zweiten Wärmequelle 6 bzw. des zweiten Kühlkreises 7 betrieben werden kann. Fällt also entsprechend Fig. 3 die erste Fördereinrichtung 8 aus oder liefert sie eine reduzierte Leistung, wobei in Fig. 3 ein Zustand dargestellt ist, bei dem die erste Fördereinrichtung 8 ausgefallen ist, erfolgt kein Fördern des Kühlmittels im ersten Kühlkreis 3, dementsprechend ist der erste Kühlkreis 3 gestrichelt dargestellt. Entsprechendes gilt für die Abzweig-Leitung 14 sowie die erste Rückführ-Leitung 20.

In Fig. 4 ist ein weiteres Ausführungsbeispiel des Kühlsystems 1 vereinfacht gezeigt, wobei in Fig. 4 der Notfallbetrieb 24 dargestellt ist. Dieses Ausführungsbeispiel unterscheidet sich von dem in den Fig. 1 bis 3 gezeigten Ausführungsbeispielen insbesondere dadurch, dass nur ein einziger solcher Druckausgleichsbehälter 23 vorgesehen ist, das fluidisch mit der Abzweig-Leitung 14 verbunden ist. Dies führ zu einem reduzierten Bauraumbedarf und eine reduzierte Anzahl von Bestandteilen des Kühlsystems 1. Zudem ist in der Abzweig-Leitung 14 kein solches Ventil 17 vorgesehen. Die fluidische Verbindung zwischen dem ersten Kühlkreis 3 und dem zweiten Kühlkreis 4 über die Abzweig-Leitung 14 kann hierbei insbesondere mit Hilfe des Druckausgleichsbehälters 23 erfolgen, die mit der Steuereinrichtung 25 kommunizierend verbunden sein kann. Dies führt dazu, dass beide Kühlkreise 3, 4 saugseitig, das heißt stromauf der Fördereinrichtungen 8, 10 auf dem gleichen Druckniveau sind. Sofern eine Priorisierung des zweiten Kühlkreises 4 erforderlich ist, kann zwischen dem Druckausgleichsbehälter 23 und der ersten Abzweigstelle 15 ein Ventil 17 vorgesehen werden (nicht gezeigt), um bei einem Ausfall der ersten Fördereinrichtung 8 und/oder bei einer Leckage im ersten Kühlkreis 3 den zweiten Kühlkreis 4 und den Druckausgleichsbehälter 23 vom ersten Kühlkreis 3 zu trennen, so dass in solchen Fällen ein geregelter Betrieb des zweiten Kühlkreises 4 weiter möglich ist.

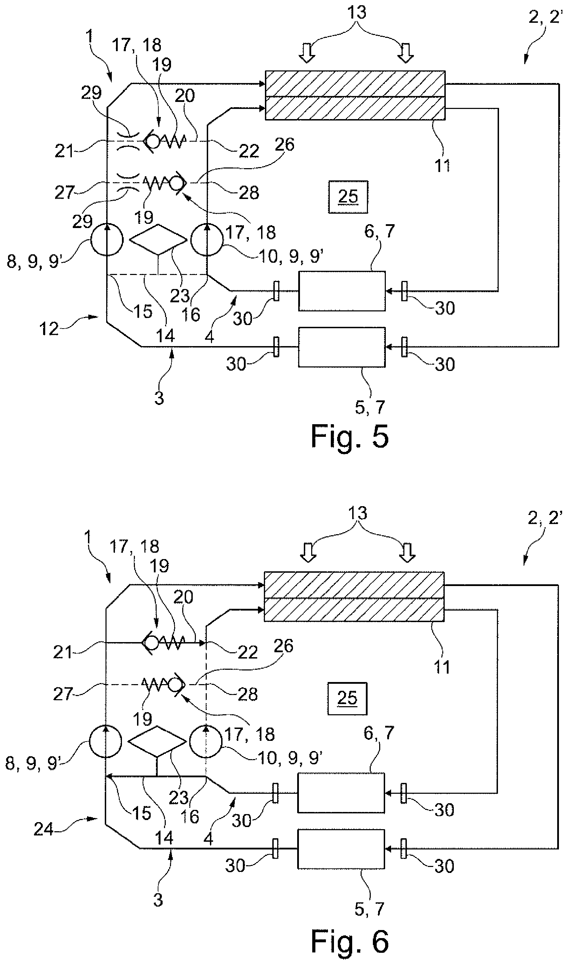

In Fig. 5 ist ein weiteres Ausführungsbeispiel des Kühlsystems 1 gezeigt, wobei in Fig. 5 der Normalbetrieb des Kühlsystems 1 erfolgt. Dieses Ausführungsbeispiel unterscheidet sich von dem in Fig. 4 gezeigten Ausführungsbeispiel insbesondere dadurch, dass die erste Rückführ-Leitung 20 stromauf des Kühlers 11 angeordnet ist. Dabei ist die erste Rückführstelle 21 der ersten Rückführ-Leitung 20 stromab der ersten Fördereinrichtung 8 und stromauf des Kühlers 11 angeordnet, während die zweite Rückführstelle 22 der ersten Rückführ-Leitung 20 stromab der zweiten Fördereinrichtung 10 und stromauf des Kühlers 11 angeordnet ist. Bei diesem Ausführungsbeispiel ist zudem eine zweite Rückführ-Leitung 26 vorgesehen, die von einer ersten Rückführstelle 27 der zweiten Rückführ-Leitung 26 im ersten Kühlkreis 3 bis zu einer zweiten Rückführstelle 28 der zweiten Rückführ-Leitung 26 im zweiten Kühlkreis 4 verläuft. Die erste Rückführstelle 27 der zweiten Rückführ-Leitung 26 ist stromauf der ersten Wärmequelle 5 angeordnet, während die zweite Rückführstelle 28 der zweiten Rückführ-Leitung 26 stromab der zweiten Fördereinrichtung 10 angeordnet ist. Im gezeigten Beispiel ist zudem die erste Rückführstelle 27 der zweiten Rückführ-Leitung 26 stromauf der ersten Rückführstelle 21 der ersten Rückführ-Leitung 20 angeordnet, während die zweite Rückführstelle 28 der zweiten Rückführ-Leitung 26 stromauf der zweiten Rückführstelle 22 der ersten Rückführ-Leitung 20 angeordnet ist, wobei auch eine umgekehrte Reihenfolge vorstellbar ist. In der zweiten Rückführ-Leitung 26 ist ein als Rückschlagventil 18 ausgebildetes Ventil 17 angeordnet, das mit einem Gegendruck beaufschlagt ist und lediglich eine Strömung des Kühlmittels vom zweiten Kühlkreis 4 zum ersten Kühlkreis 3 erlaubt. Im gezeigten Beispiel ist in der jeweiligen Rückführ-Leitung 20, 26 zudem eine Drosseleinrichtung 29 angeordnet, welche die Strömung des Kühlmittels durch die zugehörige Leitung 20, 26 regelt. Diese Regelung mittels der Drosseleinrichtung 29 kann dabei zusätzlich oder alternativ zum Ventil 17, insbesondere zum Rückschlagventil 18, erfolgen.

Beim in Fig. 5 gezeigten Normalbetrieb 12 sind dabei der erste Kühlkreis 3 und der zweite Kühlkreis 4 fluidisch getrennt. Das heißt, dass die fluidische Verbindung zwischen den Kühlkreisen 3 und 4 über die Leitungen 14, 20, 26 unterbrochen ist.

In Fig. 6 ist das Kühlsystem 1 im Notfallbetrieb 24 gezeigt, in dem die zweite Fördereinrichtung 10 eine reduzierte Leistung liefert oder ausfällt, wobei in Fig. 6 ein Zustand dargestellt ist, bei dem die zweite Fördereinrichtung 10 ausgefallen ist. In diesem Fall erfolgt, analog zu den in den Fig. 2 und 4 gezeigten Varianten, ein Abzweigen des Kühlmittels vom zweiten Kühlkreis 4 stromab der zweiten Wärmequelle 6 zum ersten Kühlkreis 3, ein Fördern des Kühlmittels durch die erste Fördereinrichtung 8 und ein Zurückführen des Kühlmittels zum zweiten Kühlkreis 4 stromauf der zweiten Wärmequelle 6. Das Abzweigen des Kühlmittels erfolgt über die Abzweig-Leitung 14, während die Rückführung des Kühlmittels über die erste Rückführ-Leitung 20 erfolgt. In Fig. 6 sind dabei der besseren Übersicht halber die Drosseleinrichtungen 29 nicht dargestellt, obwohl diese anstatt der gezeigten Ventile 17 oder alternativ zu diesen vorliegen können. Da die erste Rückführ-Leitung 20 an der zweiten Rückführstelle 22 in den zweiten Kühlkreis 4 mündet, die stromauf des Kühlers 11 angeordnet ist, wird das Kühlmittel nach dem Zurückführen zum zweiten Kühlkreis 4 durch den Kühler 11 geführt, bevor es der zweiten Wärmequelle 6 zugeführt wird. Im in Fig. 6 gezeigten Notfallbetrieb 24 ist die zweite Rückführ-Leitung 26 gesperrt, derart, dass Kühlmittel nicht zwischen dem ersten Kühlkreis 3 und dem zweiten Kühlkreis 4 strömen kann.

Mittels der zweiten Rückführ-Leitung 26 ist es aber möglich, in einem weiteren Notfallbetrieb 31, der nachfolgend als zweiter Notfallbetrieb 31 bezeichnet wird, während die zuvor erläuterten Notfallbetriebe 24 als erster Notfallbetrieb 24 bezeichnet werden, die zweite Fördereinrichtung 10 zur Förderung des Kühlmittels im ersten Kühlkreis 3 einzusetzen, wenn die erste Fördereinrichtung 8 eine reduzierte Förderleistung liefert oder ausfällt.

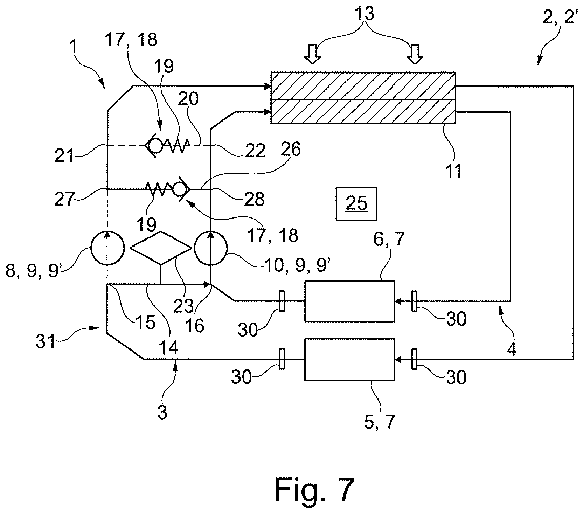

Ein solcher zweiter Notfallbetrieb 31 ist in Fig. 7 dargestellt, wobei in Fig. 7 ein Zustand gezeigt ist, bei dem die erste Fördereinrichtung 8 ausgefallen ist. Im zweiten Notfallbetrieb 31 wird Kühlmittel stromab der ersten Wärmequelle 5 vom ersten Kühlkreis 3 abgezweigt, stromauf der zweiten Fördereinrichtung 10 dem zweiten Kühlkreis 4 zugeführt und stromauf der ersten Wärmequelle 5 dem ersten Kühlkreis 3 rückgeführt. Beim gezeigten Beispiel erfolgt das Abzweigen des Kühlmittels dabei über die Abzweig-Leitung 14, während das Rückführen des Kühlmittels über die zweite Rückführ-Leitung 26 erfolgt. Dabei strömt das Kühlmittel im zweiten Kühlkreis 3 aufgrund der Anordnung der ersten Rückführstelle 27 der zweiten Rückführ-Leitung 26 im ersten Kühlkreis 3 stromauf des Kühlers 11 durch den Kühler 11, bevor es der ersten Wärmequelle 5 zugeführt wird.

Bei dem in den Fig. 5 bis 7 gezeigten Kühlsystem 1 erfolgt also keine Priorisierung eines der Kühlkreise 3, 4 bzw. der zugehörigen Wärmequelle 5, 6. Selbstverständlich ist aber möglich, eine solche Priorisierung mittels entsprechender Steuerung der Ventile 17 und/oder der Drosseleinrichtungen 29 vorzunehmen.

Bei allen gezeigten Beispielen ist es ferner möglich, in einem Unterstützungsbetrieb die Fördereinrichtung 8, 10 des anderen Kühlkreises 3, 4 zum Fördern des Kühlmittels in einem Kühlkreis 3, 4 einzusetzen, wenn in diesem Kühlkreis stromauf der zugehörigen Wärmequelle 5, 7 eine Temperatur ermittelt wird, die oberhalb eines vorgegebenen Wertes liegt. Es ist bspw. möglich, die erste Fördereinrichtung 8 zusätzlich zur zweiten Fördereinrichtung 10 zum Fördern des Kühlmittels im zweiten Kühlkreis 4 einzusetzen, wenn das Kühlmittel stromauf der zweiten Wärmequelle 6 eine Temperatur aufweist, die oberhalb des vorgegebenen Wertes liegt. Die Bestimmung der Temperatur erfolgt hierbei mittels des stromauf bzw. stromab der zweiten Wärmequelle 6 angeordneten Temperatursensors 30.

Analog hierzu kann in einem zweiten Unterstützungsbetrieb die zweite Fördereinrichtung 10 zusätzlich zur ersten Fördereinrichtung 8 zum Fördern des Kühlmittels im ersten Kühlkreis 3 eingesetzt werden, wenn stromauf der ersten Wärmequelle 5, insbesondere mittels des entsprechenden Temperatursensors 30, eine Temperatur ermittelt wird, die oberhalb eines Wertes, die sich vom Wert im ersten Unterstützungsbetrieb unterscheiden kann, liegt. Im Unterstützungsbetrieb liegt also im Vergleich zum Notfallbetrieb keine Leistungsreduzierung der zugehörigen Fördereinrichtung 8, 10 bzw. kein Ausfall der zugehörigen Fördereinrichtung 8, 10 vor.

In allen Ausführungsbeispielen erlauben ferner die entsprechenden Ventile 17 bzw. Drosseleinrichtungen 29 eine entsprechende Regelung des Volumenstroms bzw. der Menge des abgezweigten sowie zurückgeführten Kühlmittels.

## Patentansprüche

1. Verfahren zum Betreiben eines Kühlsystems (1) für ein Fahrzeugs (2), insbesondere für ein Schienenfahrzeug (2'),
- mit einem ersten Kühlkreis (3) und einem zweiten Kühlkreis (4), wobei im ersten Kühlkreis (3) und im zweiten Kühlkreis (4) ein Kühlmittel zirkuliert,
- mit einer zur Kühlung im ersten Kühlkreis (3) angeordneten ersten Wärmequelle (5),
- mit einer zur Kühlung im zweiten Kühlkreis (4) angeordneten zweiten Wärmequelle (6),
- mit einer im ersten Kühlkreis (3) angeordneten ersten Fördereinrichtung (8) zum Fördern des Kühlmittels,
- mit einer im zweiten Kühlkreis (4) angeordneten zweiten Fördereinrichtung (10) zum Fördern des Kühlmittels,
- mit zumindest einem Kühler (11) zum Kühlen des Kühlmittels,
- wobei in einem Normalbetrieb (12) beide Fördereinrichtungen (8, 10) betrieben werden,
**dadurch gekennzeichnet,**
**dass** in einem ersten Notfallbetrieb (24), in dem die zweite Fördereinrichtung (10) eine zumindest reduzierte Förderleistung zur Verfügung stellt, insbesondere ausfällt, Kühlmittel stromab der zweiten Wärmequelle (6) vom zweiten Kühlkreis (4) abgezweigt, von der ersten Fördereinrichtung (8) gefördert und stromauf der zweiten Wärmequelle (6) dem zweiten Kühlkreis (4) zurückgeführt wird.

2. Verfahren nach Anspruch 1,
**dadurch gekennzeichnet,**
**dass** in einem zweiten Notfallbetrieb (31), in dem die erste Fördereinrichtung (8) eine zumindest reduzierte Förderleistung zur Verfügung stellt, insbesondere ausfällt, Kühlmittel stromab der ersten Wärmequelle (5) vom ersten Kühlkreis (3) abgezweigt, von der zweiten Fördereinrichtung (10) gefördert und stromauf der ersten Wärmequelle (5) dem ersten Kühlkreis (3) zurückgeführt wird.

3. Verfahren nach Anspruch 1 oder 2,
**dadurch gekennzeichnet,**
**dass** in einem Unterstützungsbetrieb, in dem die Temperatur des Kühlmittels in einem der Kühlkreise (3, 4) stromauf der zugehörigen Wärmequelle (5, 6) oberhalb eines vorgegebenen Werts steigt, die Fördereinrichtung (8, 10) des anderen Kühlkreises (3, 4) zusätzlich zur Förderung des Kühlmittels im Kühlkreis (3, 4) mit der überhöhten Temperatur des Kühlmittels eingesetzt wird.

4. Kühlsystem (1) für ein Fahrzeug (2), insbesondere für ein Schienenfahrzeug (2'), mit
- einem ersten Kühlkreis (3) und einem zweiten Kühlkreis (4), wobei im ersten Kühlkreis (3) und im zweiten Kühlkreis (4) ein Kühlmittel zirkuliert,
- einer zur Kühlung im ersten Kühlkreis (3) angeordneten ersten Wärmequelle (5),
- einer zur Kühlung im zweiten Kühlkreis (4) angeordneten zweiten Wärmequelle (6),
- einer im ersten Kühlkreis (3) angeordneten ersten Fördereinrichtung (8) zum Fördern des Kühlmittels,
- einer im zweiten Kühlkreis (4) angeordneten zweiten Fördereinrichtung (10) zum Fördern des Kühlmittels,
- zumindest einem Kühler (11) zum Kühlen des Kühlmittels,
**dadurch gekennzeichnet,**
- **dass** das Kühlsystem (1) eine Abzweig-Leitung (14) zum fluidischen Verbinden des ersten Kühlkreises (3) mit dem zweiten Kühlkreis (4) stromauf der ersten Fördereinrichtung (8) und stromauf der zweiten Fördereinrichtung (10) sowie stromab der zweiten Wärmequelle (6) aufweist,
- **dass** das Kühlsystem (1) eine erste Rückführ-Leitung (20) zum fluidischen Verbinden des ersten Kühlkreises (3) mit dem zweiten Kühlkreis (4) aufweist, die stromab der ersten Fördereinrichtung (8) vom ersten Kühlkreis abzweigt und stromauf der zweiten Wärmequelle (6) in den zweiten Kühlkreis (4) mündet,
- **dass** in der ersten Rückführ-Leitung (20) ein Ventil (17) zur Regelung der Strömung des Kühlmittels angeordnet ist,
- **dass** das Kühlsystem (1) derart ausgestaltet ist, dass es gemäß dem Verfahren nach einem der Ansprüche 1 bis 3 betrieben wird.

5. Kühlsystem nach Anspruch 4,
**gekennzeichnet durch**
eine zweite Rückführ-Leitung (26) zum fluidischen Verbinden des zweiten Kühlkreises (4) mit dem ersten Kühlkreis (3), die stromab der zweiten Fördereinrichtung (10) vom zweiten Kühlkreis (4) abzweigt und stromauf der ersten Wärmequelle (5) in den ersten Kühlkreis (3) mündet, wobei in der zweiten Rückführ-Leitung (26) ein Ventil (17) zur Regelung der Strömung des Kühlmittels angeordnet ist.

6. Kühlsystem nach Anspruch 4 oder 5,
**dadurch gekennzeichnet,**
**dass** im zweiten Kühlkreis (4) stromab der zweiten Fördereinrichtung (10) und stromauf der ersten Rückführ-Leitung (20) ein derart ausgestaltetes Ventil (17) angeordnet ist, dass es die Strömung des Kühlmittels von der ersten Rückführ-Leitung (20) zur zweiten Fördereinrichtung (10) verhindert.

7. Kühlsystem nach einem der Ansprüche 4 bis 6,
**dadurch gekennzeichnet,**
**dass** in der Abzweig-Leitung (14) ein Ventil (17) zur Regelung der Strömung des Kühlmittels angeordnet ist.

8. Kühlsystem nach einem der Ansprüche 4 bis 7,
**dadurch gekennzeichnet,**
**dass** zumindest ein solches Ventil (17) als ein Rückschlagventil (18) ausgebildet ist.

9. Kühlsystem nach einem der Ansprüche 4 bis 8,
**gekennzeichnet durch**
eine Steuereinrichtung (25), die derart ausgestaltet ist, dass sie das Kühlsystem (1) nach dem Verfahren nach einem der Ansprüche 1 bis 3 betreibt.

10. Kühlsystem nach einem der Ansprüche 4 bis 9,
**dadurch gekennzeichnet,**
**dass** das Kühlsystem (1) zumindest einen Druckausgleichsbehälter (23) zum Ausgleich des Drucks im Kühlmittel aufweist.

11. Kühlsystem nach Anspruch 10,
**dadurch gekennzeichnet,**
**dass** ein solcher erster Druckausgleichsbehälter (23') und ein solcher zweiter Druckausgleichsbehälter (23") vorgesehen sind, wobei der erste Druckausgleichsbehälter (23') dem ersten Kühlkreis (3) zugeordnet ist und der zweite Druckausgleichsbehälter (23") dem zweiten Kühlkreis (4) zugeordnet ist.

12. Kühlsystem nach einem der Ansprüche 4 bis 11,
**dadurch gekennzeichnet,**
**dass** die Abzweig-Leitung (14) stromauf zumindest eines solchen Kühlers (11) angeordnet ist.

13. Kühlsystem nach einem der Ansprüche 4 bis 12,
**dadurch gekennzeichnet,**
**dass** in zumindest einer der Leitungen (14, 20, 26) eine Drosseleinrichtung (29) zum Regeln der Strömung durch die Leitung (14, 20, 26) angeordnet ist.

14. Kühlsystem nach einem der Ansprüche 4 bis 13,
**dadurch gekennzeichnet,**
**dass** ein gemeinsamer solcher Kühler (11) zum Kühlen des Kühlmittels im ersten Kühlkreis (3) und im zweiten Kühlkreis (4) vorgesehen ist.

## Claims

1. Method for operating a cooling system (1) for a vehicle (2), in particular a rail vehicle (2') comprising:
- a first cooling circuit (3) and a second cooling circuit (4), wherein a coolant circulates in the first cooling circuit (3) and the second cooling circuit (4)
- a first heat source (5) arranged for cooling in the first cooling circuit (3),
- a second heat source (6) arranged for cooling in the second cooling circuit (4),
- a first pumping device (8) arranged in the first cooling circuit (3) for pumping the coolant,
- a second pumping device (10) arranged in the second cooling circuit (4) for pumping the coolant,
- at least one cooler (11) for cooling the coolant,
- wherein (in normal mode (12)) both pumping devices (8, 10) are operated,
**characterised in that**
in a first emergency mode (24) in which the second pumping device (10) provides at least reduced pumping capacity, in particular stops working, the coolant is diverted from the second cooling circuit (4) downstream of the second heat source (6) and pumped by the first pumping device (8) and returned to the second cooling circuit (4) upstream of the second heat source (6).

2. Method according to claim 1,
**characterised in that**
in a second emergency mode (31) in which the first pumping device (8) provides at least reduced pumping capacity, in particular stops working, the coolant from the first cooling circuit (3) is diverted downstream of the first heat source (5) and pumped by the second pumping device (10) and returned to the first cooling circuit (3) upstream of the first heat source (5).

3. Method according to claim 1 or 2,
**characterised in that**
in a support mode in which the temperature of the coolant in one of the cooling circuits (3, 4) upstream of the associated heat source (5, 6) increases above a predefined level, the pumping device (8, 10) of the other cooling circuit (3, 4) is used in addition for pumping the coolant in the cooling circuit (3, 4) at the raised temperature of the coolant.

4. Cooling system (1) for a vehicle (2), in particular for a rail vehicle (2') comprising:
- a first cooling circuit (3) and a second cooling circuit (4), wherein a coolant circulates in the first cooling circuit (3) and in the second cooling circuit (4),
- a first heat source (5) arranged for cooling in the first cooling circuit (3),
- a second heat source (6) arranged for cooling in the second cooling circuit (4),
- a first pumping device (8) arranged in the first cooling circuit (3) for pumping the coolant,
- a second pumping device (10) arranged in the second cooling circuit (4) for pumping the coolant,
- at least one cooler (11) for cooling the coolant,
**characterised in that**
- the cooling system (1) comprises a branch line (14) providing a fluidic connection between the first cooling circuit (3) and the second cooling circuit (4) upstream of the first pumping device (8) and upstream of the second pumping device (10) and downstream of the second heat source (6),
- the cooling system (1) comprises a first return line (20) providing a fluidic connection between the first cooling circuit (3) and the second cooling circuit (4), which first return line branches off from the first cooling circuit downstream of the first pumping device (8) and opens into the second cooling circuit (4) upstream of the second heat source (6),
- a valve (17) for regulating the flow of coolant is arranged in the first return line (20),
- the cooling system (1) is configured such that it is operated according to the method of any of claims 1 to 3.

5. Cooling system according to claim 4, **characterised by** a second return line (26) providing a fluidic connection between the second cooling circuit (4) and the first cooling circuit (3), wherein the second return line branches off from the second cooling circuit (4) downstream of the second pumping device (10) and opens into the first cooling circuit (3) upstream of the first heat source (5), wherein a valve (17) for regulating the flow of coolant is arranged in the second return line (26).

6. Cooling system according to claim 4 or 5 **characterised in that** a valve (17) configured in this way is arranged in the second cooling circuit (4) downstream of the second pumping device (10) and upstream of the first return line (20) wherein it prevents the flow of coolant from the first return line (20) to the second pumping device (10).

7. Cooling system according to any of claims 4 to 6, **characterised in that** a valve (17) for regulating the flow of the coolant is arranged in the branch line (14).

8. Cooling system according to any of claims 4 to 7, **characterised in that** at least one such valve (17) is configured as a non-return valve (18).

9. Cooling system according to any of claims 4 to 8, **characterised by** a control device (25) which is configured such that it operates the cooling system (1) according to the method of any of claims 1 to 3.

10. Cooling system according to any of claims 4 to 9, **characterised in that** the cooling system (1) comprises at least one pressure-equalising container (23) for equalising the pressure in the coolant.

11. Cooling system according to claim 10, **characterised in that** such a first pressure equalising container (23') and such a second pressure equalising container (23") are provided, wherein the first pressure equalising container (23') is assigned to the first cooling circuit (3) and the second pressure equalising container (23") is assigned to the second cooling circuit (4).

12. Cooling system according to any of claims 4 to 11, **characterised in that** the branch line (14) is located upstream of at least one such cooler (11).

13. Cooling system according to any of claims 4 to 12, **characterised in that** a throttling device (29) for regulating the through the line (14, 20, 26) is arranged in at least one of the lines (14, 20, 26).

14. Cooling system according to any of claims 4 to 13, **characterised in that** a common cooler (11) is provided for cooling the coolant in the first cooling circuit (3) and in the second cooling circuit (4).

## Revendications

1. Procédé servant à faire fonctionner un système de refroidissement (1) pour un véhicule (2), en particulier pour un véhicule sur rails (2'),
- avec un premier circuit de refroidissement (3) et un deuxième circuit de refroidissement (4), dans lequel un liquide de refroidissement circule dans le premier circuit de refroidissement (3) et dans le deuxième circuit de refroidissement (4),
- avec une première source de chaleur (5) disposée dans le premier circuit de refroidissement (3) aux fins du refroidissement,
- avec une deuxième source de chaleur (6) disposée dans le deuxième circuit de refroidissement (4) aux fins du refroidissement,
- avec un premier dispositif de refoulement (8) disposé dans le premier circuit de refroidissement (3), servant à refouler le liquide de refroidissement,
- avec un deuxième dispositif de refoulement (10) disposé dans le deuxième circuit de refroidissement (4), servant à refouler le liquide de refroidissement,
- avec au moins un refroidisseur (11) servant à refroidir le liquide de refroidissement,
- dans lequel les deux dispositifs de refoulement (8, 10) fonctionnent dans un mode de fonctionnement normal (12),
**caractérisé en ce**
**que** dans un premier mode de fonctionnement d'urgence (24), dans lequel le deuxième dispositif de refoulement (10) fournit une puissance de refoulement au moins réduite, en particulier tombe en panne, du liquide de refroidissement est dévié en aval de la deuxième source de chaleur (6) du deuxième circuit de refroidissement (4), est refoulé par le premier dispositif de refoulement (8) et est ramené au deuxième circuit de refroidissement (4) en amont de la deuxième source de chaleur (6).

2. Procédé selon la revendication 1,
**caractérisé en ce**
**que** dans un deuxième mode de fonctionnement d'urgence (31), dans lequel le premier dispositif de refoulement (8) fournit une puissance de refoulement au moins réduite, en particulier tombe en panne, du liquide de refroidissement est dévié en aval de la première source de chaleur (5) du premier circuit de refroidissement (3), est refoulé par le deuxième dispositif de refoulement (10) et est ramené au premier circuit de refroidissement (3) en amont de la première source de chaleur (5).

3. Procédé selon la revendication 1 ou 2,
**caractérisé en ce**
**que** dans un mode de fonctionnement d'assistance, dans lequel la température du liquide de refroidissement monte, dans un des circuits de refroidissement (3, 4), en amont de la source de chaleur (5, 6) associée, au-dessus d'une valeur spécifiée, le dispositif de refoulement (8, 10) de l'autre circuit de refroidissement (3, 4) est utilisé en supplément aux fins du refoulement du liquide de refroidissement dans le circuit de refroidissement (3, 4) avec la température excessive du liquide de refroidissement.

4. Système de refroidissement (1) pour un véhicule (2), en particulier pour un véhicule sur rails (2'), avec
- un premier circuit de refroidissement (3) et un deuxième circuit de refroidissement (4), dans lequel un liquide de refroidissement circule dans le premier circuit de refroidissement (3) et dans le deuxième circuit de refroidissement (4),
- une première source de chaleur (5) disposée dans le premier circuit de refroidissement (3) aux fins du refroidissement,
- une deuxième source de chaleur (6) disposée dans le deuxième circuit de refroidissement (4) aux fins du refroidissement,
- un premier dispositif de refoulement (8) disposé dans le premier circuit de refroidissement (3), servant à refouler le liquide de refroidissement,
- un deuxième dispositif de refroidissement (10) disposé dans le deuxième circuit de refroidissement (4), servant à refouler le liquide de refroidissement,
- au moins un refroidisseur (11) servant à refroidir le liquide de refroidissement,
**caractérisé en ce**
- **que** le système de refroidissement (1) présente un conduit de déviation (14) servant à relier de manière fluidique le premier circuit de refroidissement (3) au deuxième circuit de refroidissement (4) en amont du premier dispositif de refoulement (8) et en amont du deuxième dispositif de refoulement (10) ainsi qu'en aval de la deuxième source de chaleur (6),
- **que** le système de refroidissement (1) présente un premier conduit de retour (20) servant à relier de manière fluidique le premier circuit de refroidissement (3) au deuxième circuit de refroidissement (4), qui forme une déviation avec le premier circuit de refroidissement en aval du premier dispositif de refoulement (8) et débouche dans le deuxième circuit de refroidissement (4) en amont de la deuxième source de chaleur (6),
- **qu'**une soupape (17) servant à réguler l'écoulement du liquide de refroidissement est disposée dans le premier conduit de retour (20),
- **que** le système de refroidissement (1) est configuré de telle manière qu'il fonctionne selon le procédé selon l'une quelconque des revendications 1 à 3.

5. Système de refroidissement selon la revendication 4,
**caractérisé par**
un deuxième conduit de retour (26) servant à relier de manière fluidique le deuxième circuit de refroidissement (4) au premier circuit de refroidissement (3), qui forme une déviation avec le deuxième circuit de refroidissement (4) en aval du deuxième dispositif de refoulement (10) et débouche dans le premier circuit de refroidissement (3) en amont de la première source de chaleur (5), dans lequel une soupape (17) servant à réguler l'écoulement du liquide de refroidissement est disposée dans le deuxième conduit de retour (26).

6. Système de refroidissement selon la revendication 4 ou 5,
**caractérisé en ce**
**qu'**est disposée dans le deuxième circuit de refroidissement (4) en aval du deuxième dispositif de refoulement (10) et en amont du premier conduit de retour (20), une soupape (17) configurée de telle manière qu'elle empêche l'écoulement du liquide de refroidissement depuis le premier conduit de retour (20) vers le deuxième dispositif de refoulement (10).

7. Système de refroidissement selon l'une quelconque des revendications 4 à 6,
**caractérisé en ce**
**qu'**une soupape (17) servant à réguler l'écoulement du liquide de refroidissement est disposée dans le conduit de déviation (14).

8. Système de refroidissement selon l'une quelconque des revendications 4 à 7,
**caractérisé en ce**
**qu'**au moins une soupape (17) de ce type est réalisée sous la forme d'une soupape anti-retour (18).

9. Système de refroidissement selon l'une quelconque des revendications 4 à 8,
**caractérisé par**
un dispositif de commande (25), qui est configuré de telle manière qu'il fait fonctionner le système de refroidissement (1) selon le procédé selon l'une quelconque des revendications 1 à 3.

10. Système de refroidissement selon l'une quelconque des revendications 4 à 9,
**caractérisé en ce**
**que** le système de refroidissement (1) présente au moins un contenant de compensation de pression (23) servant à compenser la pression dans le liquide de refroidissement.

11. Système de refroidissement selon la revendication 10,
**caractérisé en ce**
**qu'**un premier contenant de compensation de pression (23') de ce type et un deuxième contenant de compensation de pression (23") de ce type sont prévus, dans lequel le premier contenant de compensation de pression (23') est associé au premier circuit de refroidissement (3) et le deuxième contenant de compensation de pression (23") est associé au deuxième circuit de refroidissement (4).

12. Système de refroidissement selon l'une quelconque des revendications 4 à 11,
**caractérisé en ce**
**que** le conduit de déviation (14) est disposé en aval d'au moins un refroidisseur (11) de ce type.

13. Système de refroidissement selon l'une quelconque des revendications 4 à 12,
**caractérisé en ce**
**qu'**un dispositif d'étranglement (29) servant à réguler l'écoulement à travers le conduit (14, 20, 26) est disposé dans au moins un des conduits (14, 20, 26).

14. Système de refroidissement selon l'une quelconque des revendications 4 à 13,
**caractérisé en ce**
**qu'**un refroidisseur (11) commun de ce type est prévu pour refroidir le liquide de refroidissement dans le premier circuit de refroidissement (3) et dans le deuxième circuit de refroidissement (4).
